# EUROPEAN PATENT APPLICATION

(11) **EP 4 428 556 A1**
(43) Date of publication of application: **11.09.2024**
(21) Application number: 24157755.0
(22) Date of filing: 15.02.2024
(51) Int. Cl.: G01R 33/3415, G01R 33/36

(54) **COIL UNIT AND MAGNETIC RESONANCE IMAGING APPARATUS INCLUDING COIL UNIT**

(30) Priority: 08.03.2023 JP 2023035703
(71) Applicant: FUJIFILM Healthcare Corporation, Kashiwa-shi, Chiba 277-0804 (JP)
(72) Inventor: OTAKE, Yosuke, Chiba, 277-0804 (JP); DOHATA, Masayoshi, Chiba, 277-0804 (JP)
(74) Representative: Strehl Schübel-Hopf & Partner

(57) **Abstract**

Provided is a coil unit for a reception coil, which can avoid interference between high-frequency circuits included in the reception coil and coupling with a transmission coil and can suppress an influence of the transmission coil on the high-frequency circuit of the reception coil.

A coil unit of an MRI apparatus includes a plurality of coil elements arranged in a two-dimensional direction, a wiring line connected to each coil element and configured to bundle a signal line, and baluns provided at a plurality of positions of the wiring line, in which at least a part of the wiring line runs from one end toward other end in an arrangement direction of the coil elements while being folded back in a direction oblique to the arrangement direction.

## Description

### INCORPORATION BY REFERENCE

The present application claims priority from Japanese patent application JP-2023-035703 filed on March 8, 2023, the content of which is hereby incorporated by reference into this application.

### BACKGROUND OF THE INVENTION

### 1. Field of the Invention

The present invention relates to a reception coil unit comprising a plurality of coil elements used in an MRI apparatus, and particularly to a reception coil unit comprising a reception coil element and a balun for preventing interference between a transmission coil and a wiring line.

### 2. Description of the Related Art

In magnetic resonance imaging (MRI), as the number of channels of a reception coil increases, the image quality is generally improved, and thus multi-channelization is advanced. For the purpose of further improving the workflow, coil units having a large number of channels and a wide sensitivity region are proposed in order to image a plurality of parts with one coil setting (JP7073367B).

A normal RF coil (antenna) is composed of high-frequency circuits with a coil element, a wiring line, and a filter, and these high-frequency circuits interfere with each other, so that a problem such as a failure or abnormal heat generation is likely to occur. In an RF coil for MRI, since an irradiation RF (RF signal emitted from a transmission coil) may be non-uniform because of an influence of a magnetic field change or the like caused by the interference, which may cause a decrease in image quality, it is necessary to drive an individual of high-frequency circuits independently so that the individual of high-frequency circuits does not interfere with other high-frequency circuits.

However, as the number of channels of a reception coil increases as described above, or as a size of a coil increases, the number and length of electrical wiring lines (electrical conductors) increase, and thus the electrical interference also increases, whereby the image quality of MRI is degraded.

In order to remove interference between high-frequency circuits and the wiring line of a reception coil, there is a method of installing a plurality of baluns, which are a kind of filter circuits. For example, JP2020-500074A discloses an RF coil in which a plurality of coil elements arranged on a plane are wired through a center of the arrangement, and baluns are disposed at a plurality of positions of the wiring line.

### SUMMARY OF THE INVENTION

In the above-described coil unit having a large number of channels, development for reducing a thickness and weight is advanced in order to improve the ease of use. Here, in a case where the reception coil is thinned, a thickness of the member covering the reception coil is reduced, and the high-frequency circuits constituting the reception coil are close to a transmission coil that handles high power. Accordingly, interference between the reception coil and the transmission coil is also increased. Since the reception coil used in the MRI is a weak current circuit that handles power that is smaller than that of the transmission coil by 6 digits or more, there is a concern that the high-frequency circuits included in the reception coil may abnormally generate heat or may be broken due to interference with the transmission coil.

In the reception coil disclosed in JP2020-500074A, high-frequency interference occurring in a wiring line of the reception coil can be suppressed by providing a balun, but the increase in the interference with the transmission coil, in which a distance therebetween is decreased because of the thinning, is not considered.

In MRI, a birdcage-type coil in which two ring conductors are connected by a plurality of rung conductors is frequently used as an RF transmission coil (also referred to as an irradiation coil). In a case where a reception coil is set in a state where a wiring line on which a plurality of baluns are formed as in the reception coil disclosed in JP2020-500074A is positioned directly below the conductor of the birdcage-type coil, the wiring line and the conductor of the transmission coil, for example, the rung conductor are parallel to each other and are close to each other, and thus are electromagnetically strongly coupled and interfere with each other. A setting position of the reception coil on a subject is different depending on a test part, but a large-sized reception coil covering a wide region of the subject is set such that an arrangement direction of coil loops (coil elements) is along a body axis of the subject. In general, a wiring line of a reception coil is designed to be substantially in a straight line along the arrangement direction of coil elements so that the wiring line has a minimum length in order to suppress high-frequency interference. Therefore, in the reception coil of the related art, the wiring of the reception coil and the rung conductor of the transmission coil are substantially parallel to each other. Even in a case where the reception coil is rotated by 90 degrees and set, the ring conductor and the wiring line are in a parallel relationship, and the disposition in which the reception coil and the transmission coil strongly interfere with each other is obtained.

An object of the present invention is to provide a reception coil (coil unit) that can avoid interference between high-frequency circuits included in the reception coil and coupling with the transmission coil, and can suppress an influence of a transmission coil on the high-frequency circuits of the reception coil.

In order to solve the above-described problem, the present invention has a configured in which a wiring line that bundles a plurality of coil elements constituting a coil unit runs while being folded back so as to extend in a plurality of directions, that is, in a zigzag shape. In addition, the balun that prevents interference between the high-frequency circuits is disposed on a folding-back point, or between one folding-back point and a next folding-back point.

That is, the coil unit according to an aspect of the present invention is a coil unit used for a reception coil of an MRI, the coil unit comprises a plurality of coil elements arranged in a two-dimensional direction; a wiring line connected to each coil element and configured to transmit a signal or electricity; and baluns provided at a plurality of positions of the wiring line, in which at least a part of the wiring line runs from one end toward the other end in an arrangement direction of the coil elements while being folded back in a direction oblique to the arrangement direction.

Further, the MRI apparatus according to an aspect of the present invention comprises the above-described coil unit according to an aspect of the present invention as a reception coil.

The term "zigzag shape" means a sawtooth shape, that is, a shape that is bent, by applying an angle with respect to the arrangement direction of the coil elements, right and left alternately at least twice or more at a given interval or a random length.

In the coil unit according to an aspect of the present invention, the wiring line is disposed to form a predetermined angle or to have different lengths on both sides of the balun as a center. Accordingly, even in a case where one of the wiring lines on both sides of the balun is parallel to the conductor of the transmission coil, electromagnetic coupling between the wiring line and the conductor of the transmission coil, which is generated around the balun, is weakened, and the heat generation in the vicinity of the balun can be reduced. For example, in a case where the wiring lines on both sides of the balun are at an oblique angle in different directions, since one wiring line is directed to a direction away from the conductor regardless of the direction in which the conductor of the transmission coil is, heat generation in the vicinity of the balun is reduced.

### BRIEF DESCRIPTION OF THE DRAWINGS

Fig. 1 is an overall configuration diagram of an MRI apparatus to which the present invention is applied.
Fig. 2 is a diagram showing a relationship between an RF coil and a subject in the MRI apparatus.
Fig. 3 is a diagram showing a reception coil according to Embodiment 1.
Fig. 4 is a diagram showing an example of a balun comprised in the reception coil according to an aspect of the present invention.
Fig. 5 is a diagram showing an impedance characteristic of the balun.
Fig. 6 is a diagram illustrating a difference in configuration between the reception coil according to Embodiment 1 and a reception coil of the related art.
Fig. 7 is a diagram illustrating an effect of the reception coil according to Embodiment 1.
Fig. 8 is a diagram illustrating a positional relationship between the reception coil and a conductor of a transmission coil according to Embodiment 1.
Fig. 9 is a diagram showing a modification example of an RF reception coil according to Embodiment 1.
Figs. 10A and 10B are diagrams showing other modification examples of the RF reception coil according to Embodiment 1, respectively.
Fig. 11 is a diagram showing another example of the balun.
Figs. 12A and 12B are diagrams showing an equivalent circuit of a clamp-type balun.
Fig. 13 is a diagram showing an RF reception coil according to Embodiment 2.
Fig. 14 is a diagram illustrating an effect of the RF reception coil according to Embodiment 2.

### DESCRIPTION OF THE PREFERRED EMBODIMENTS

Hereinafter, embodiments of a coil unit and an MRI apparatus according to an aspect of the present invention will be described.

### Embodiment of MRI Apparatus

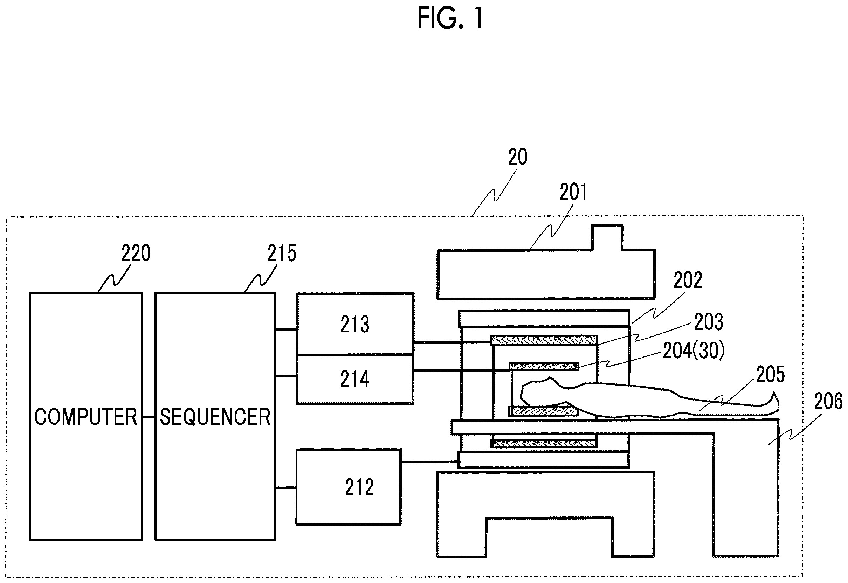

First, an overall configuration of an MRI apparatus to which the present invention is applied will be described with reference to Fig. 1.

Fig. 1 is a block diagram showing a schematic configuration of an MRI apparatus 20. As shown in Fig. 1, the MRI apparatus 20 comprises a static magnetic field generation magnet 201 that generates a static magnetic field, a gradient magnetic field coil 202, an RF transmission coil (hereinafter, simply referred to as a transmission coil) 203, an RF reception coil (hereinafter, simply referred to as a reception coil) 204, a gradient magnetic field power source 212, a transmitter 213, a receiver 214, a sequencer 215, and a computer (PC) 220. A subject 205 is disposed on a table 206 and is disposed in a static magnetic field space formed by the static magnetic field generation magnet 201.

The MRI apparatus 20 according to the present embodiment is characterized in that the coil unit according to an aspect of the present invention is used as the reception coil 204, configurations of the respective coils for magnetic field generation and the power sources that drive the respective coils, the sequencer 215, and the computer 220, except for the reception coil 204, are the same as those of a known MRI apparatus 20, and detailed description of each unit will be omitted in the present specification.

For the MRI apparatus 20, there are a horizontal magnetic field type and a vertical magnetic field type according to a direction of a generated static magnetic field. Usually, in the MRI apparatus 20 of the horizontal magnetic field type, a tunnel-type magnet comprising a solenoid coil is used as the static magnetic field generation magnet 201, and in the MRI apparatus 20 of the vertical magnetic field type, an open-type magnet in which magnets are separated in a vertical direction is used. The present invention can be applied to the MRI apparatuses 20 of both the horizontal magnetic field type and the vertical magnetic field type.

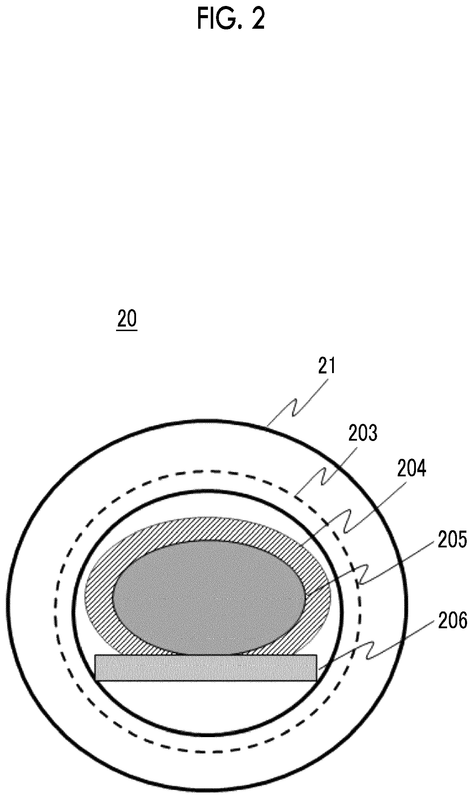

Fig. 2 is a diagram showing, as an example, an MRI apparatus of the horizontal magnetic field type including the tunnel-type magnet (not shown), the transmission coil 203 is housed in a gantry 21 together with the tunnel-type magnet and a gradient magnetic field magnet (not shown), and an imaging space that is a static magnetic field space is provided in a bore of the gantry 21. Inside the gantry 21, the static magnetic field magnet, the gradient magnetic field magnet, and the transmission coil 203 are disposed in this order from an outside.

In the MRI apparatus of a horizontal magnetic field type, the representative transmission coil 203 is a birdcage-type coil. There are various shapes for the birdcage-type coil, but basically, the birdcage-type coil has a structure comprising two ring conductors disposed away from each other and a plurality of rung conductors that mechanically and electrically connect the two ring conductors. An electronic circuit (a capacitor or the like) for adjusting a resonance frequency, a magnetic coupling prevention circuit for preventing magnetic coupling with the reception coil 204, or the like are inserted into at least a part of each of the ring conductors and the rung conductors to constitute one transmission coil 203.

In the present embodiment, the reception coil 204 is composed of a coil unit including a large number of coil elements. The coil unit comprises a plurality of coil elements that are two-dimensionally arranged, one or a plurality of wiring lines that bundle signal lines from the coil elements, a balun that is provided on the one or the plurality of wiring lines, and a cable connected part (terminal part) for connecting the wiring line of the coil elements to a cable on a receiver 214 side, and these are supported by a flexible or rigid support body, or are covered by a cover to constitute the reception coil 204. A coil unit adopted by the MRI apparatus of the present embodiment is characterized in that the wiring line and the balun are disposed such that the wiring line runs while being folded back. The details of a structure of the coil unit will be described later.

The subject 205 is placed on the table 206 in a state where the above reception coil 204 is attached to a part of a body (a relatively wide region such as an abdomen), and is positioned in the imaging space, and imaging is performed.

The flow of imaging is the same as that of a known MRI apparatus, the subject 205 disposed in the imaging space in which a static magnetic field is generated is irradiated with high-frequency magnetic field from the transmission coil 203, and a nuclear magnetic resonance signal generated from the subject 205 thereby is received by a reception coil 204. In this case, the gradient magnetic field coil 202 applies a gradient magnetic field in a pulsed manner to impart positional information to the nuclear magnetic resonance signal. These series of operations are controlled in accordance with a pulse sequence set in the sequencer 215. The computer 220 controls an operation of imaging in accordance with the control of the sequencer 215, performs various kinds of computing including image reconstruction on the nuclear magnetic resonance signal collected via the receiver 214, and generates various images related to the subject 205.

There are various factors that affect an image quality of the image generated by the MRI apparatus 20, but the design of the transmission coil 203 that irradiates the subject 205 with an RF pulse and the design of the reception coil 204 that receives the nuclear magnetic resonance signal from the subject are important factors. In particular, the reception coil 204, which is multi-channeled and covers a wide range of the abdomen of the subject 205 as described above, has a decreased distance to the transmission coil 203, so that the influence from interference between high-frequency circuits included in the coil unit and interference between the high-frequency circuits and the transmission coil is large, as shown in Fig. 2.

In the present embodiment, in the coil unit used as the reception coil 204, a disposition between the balun, which suppresses interference between the high-frequency circuits, and the wiring line is adjusted to set a running direction of the wiring line in a zigzag shape (sawtooth shape: a shape that is bent, by applying an angle, right and left alternately at least twice or more at a given interval or a random length), whereby it is possible to suppress interference with the transmission coil, to prevent image quality degradation due to the interference, and to prevent damage to the reception coil.

### Embodiment of Coil Unit

Next, embodiments of the coil unit according to an aspect of the present invention will be described.

In the following embodiments, it is common for the coil unit that a plurality of coil elements are arranged two-dimensionally or in a planar shape, wiring line of each coil element is bundled and runs toward an end part (the cable connected part to the cable on the receiver side) of the coil unit, a plurality of baluns are provided in the wiring line, and the wiring line runs in a zigzag manner with respect to a running direction toward the end part. However, the number and the arrangement of the coil elements, installation positions and the number of the baluns in the wiring line, a position of the cable connected part, and configurations of the baluns can take various forms, and various combinations of the respective forms are also possible. The embodiments described below is an example, and the coil unit according to an aspect of the present invention is not limited to the embodiments.

The term "two-dimensionally or in a plane" for the arrangement of the coil elements is used in a broad sense including not only a geometrically planar state but also a partially distorted state, a curved state, or the like.

### Embodiment 1

The coil unit according to the present embodiment is characterized in that the baluns are disposed substantially at a folding-back point of the wiring line, and disposition positions of the baluns are in a zigzag disposition, so that orientations of the wiring line on both sides of the baluns are not parallel to each other and run in a zigzag shape.

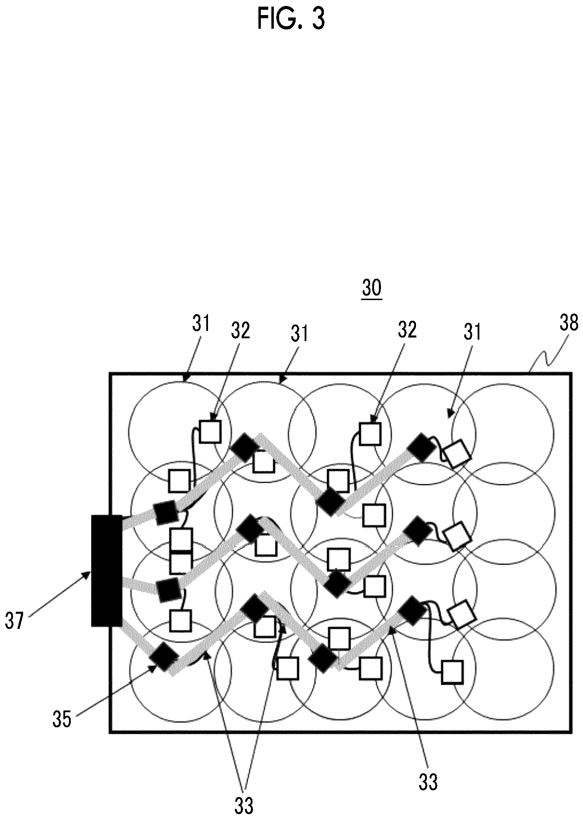

Fig. 3 shows an example of a coil unit 30 according to the present embodiment. The coil unit 30 comprises a plurality of coil elements 31, a signal detection circuit 32 connected to each of the coil elements 31, a wiring line for connecting the signal detection circuit 32 to a cable on a receiver side, baluns 35 provided at a plurality of positions of the wiring line, and a cable connected part 37, and these are fixed to a support body 38 to constitute the coil unit. In Fig. 3, a case where the number of coil elements is 20 and the coil elements are arranged in a planar shape of five columns and four rows is shown for simplicity of description, but the number and the arrangement of coil elements are not limited to those shown in Fig. 3. In addition, although the same circular loop coils are shown as the shape of the coil element 31, a figure-eight-shaped coil or various shapes may be adopted, or the shapes may be different for each coil element 31. Although not shown in Fig. 3, an electronic circuit for adjusting a resonance frequency, a magnetic coupling prevention circuit for transmission and reception, or the like is inserted into the coil elements 31 as necessary.

Each signal line that is led from the signal detection circuit 32 of the coil element 31 is sequentially bundled from one end to the other end of the coil element 31 in an arrangement direction, and is connected to the cable connected part 37 as an assembly wiring line 33. An electrical wire for supplying electricity to the electronic circuit included in the coil element is connected to each coil element 31 separately from the signal lines that is out from the signal detection circuit 32, and is bundled with the signal line (wiring line). Here, the wiring line includes one signal line and a bundle of one or a plurality of signal lines, and the latter is particularly referred to as the assembly wiring line 33.

A plurality of baluns 35 are provided in the assembly wiring line 33 in order to prevent interference with the coil element 31. The baluns 35 are provided at a plurality of positions in one assembly wiring line 33 and are disposed such that orientations of the assembly wiring lines 33 are at an angle with each other before and after the balun 35. That is, the balun 35 is disposed at a folding-back point of the assembly wiring line 33 that runs in a zigzag shape from one end toward the other end. In Fig. 3, an example in which the balun 35 is provided at all the folding-back points is shown, but there may be a folding-back point at which the balun 35 is not provided.

In addition, the balun 35 may be mounted not only on the assembly wiring line 33 in which the signal line is bundled but also inside the signal detection circuit 32 of each coil element 31, or may be provided in a connecting part between the signal detection circuit 32 and the signal line or in the signal line. In that case, it is preferable that the signal line and the assembly wiring line 33 that bundle the signal line are disposed to form a predetermined angle.

The angle at which the wiring line positioned on both sides of the balun 35 is bent varies depending on the disposition of the balun 35, but is not particularly limited as long as the assembly wiring line 33 eventually connects coil elements 31 from the coil element 31 on one end side (rightmost column in Fig. 3) to the coil element 31 on the other end side (leftmost column) to the cable connected part 37. However, since a length of the entire wiring line is increased in a case where the angle is too large, the angle is preferably about ± 45 degrees or less with respect to the arrangement direction (right-left direction in Fig. 3) of the elements.

In addition, a distance of the assembly wiring line 33 between one balun 35 and another balun 35 is preferably 1/16 or less of a wavelength (a reciprocal of a frequency of the nuclear magnetic resonance signal) λ of the high frequency that is used. As a result, it is possible to effectively suppress a resonance of the cable itself. Specifically, in a case where a nuclear magnetic resonance frequency f0 is 64 MHz, the length is about 29 cm or less.

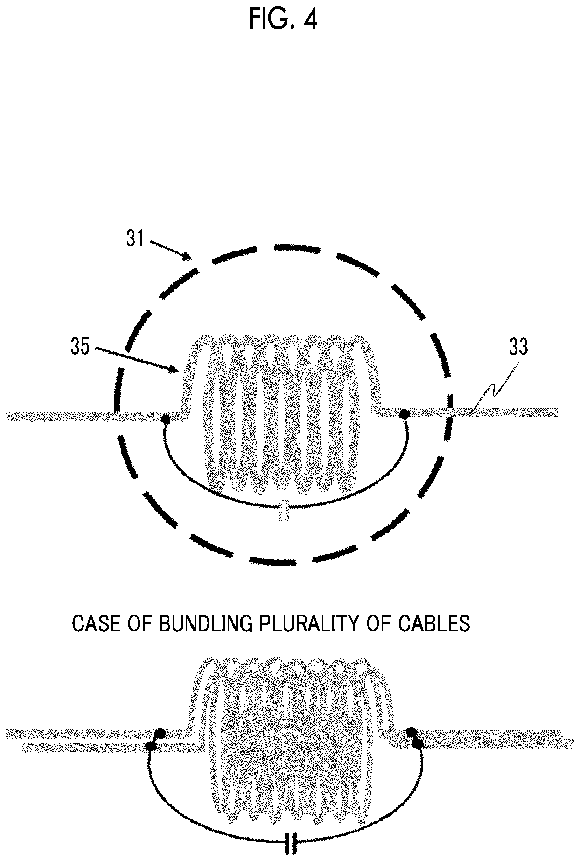

The balun 35 is a circuit having a high impedance characteristic with respect to the frequency of the high frequency that is used (the resonance frequency of the coil element 31), and can be configured with, for example, a parallel resonance circuit of an inductance component of the cable and a capacitor as shown in Fig. 4. The parallel resonance circuit shown on the upper side of Fig. 4 is a circuit in which one wire itself (a bundle of one or a plurality of signal lines) is formed in a solenoid shape to form a reactance (L) circuit, and a capacitor (C) is connected in parallel to both ends thereof. In a case where the wiring line is a coaxial cable, the capacitor is connected to a shield thereof. In a case where the balun is provided in a plurality of coaxial cables, each of the coaxial cables may be formed in a solenoid shape, and one capacitor common to the shields of the coaxial cables may be connected as shown on the lower side of Fig. 4.

By forming the balun in a solenoid shape, it is possible to form a balun having a high blocking capacity against interference with the reception coil (coil element).

The balun 35 having such a configuration is preferably disposed such that an axis of the solenoid is parallel to a loop surface of the coil element. As a result, the interference between the balun and the coil element can be reduced. In order to further suppress the interference with the coil element and the decrease in sensitivity, it is preferable that the balun is disposed symmetrically with respect to a center of the loop.

The balun 35 can have the high impedance characteristic with respect to a desired frequency by adjusting values of capacitance and reactance of the parallel resonance circuit, and can suppress the interference with the reception coil.

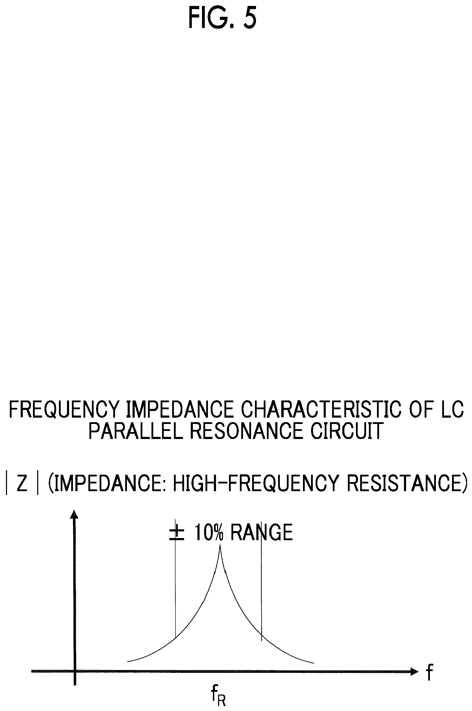

Specifically, in a case where the frequency of the high frequency that is used (the resonance frequency of the reception coil) is denoted by fR, the impedance characteristic of the balun 35 is preferably high impedance in a frequency range of fR ± 10%. Fig. 5 shows a suitable frequency impedance characteristic of the balun. In this example, a frequency at which the impedance is the highest matches the resonance frequency of the reception coil, and the interference with the reception coil can be effectively prevented. Further, by providing a width (in a range of ± 10%) in a frequency region having high impedance, it is possible to suppress heat generation (the generated heat is proportional to the impedance and the square of the current) caused by the intensive high impedance at fR.

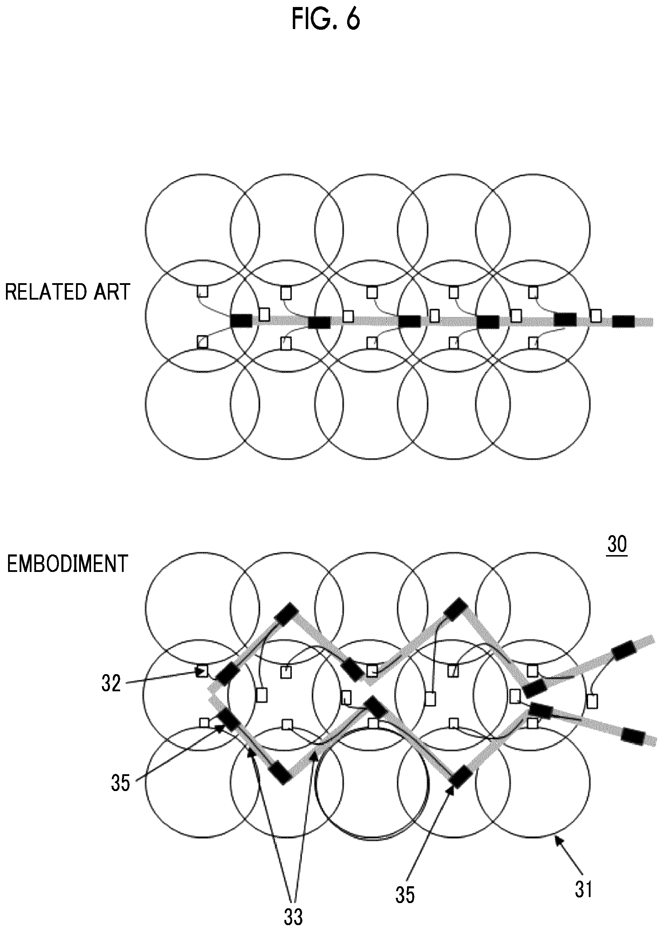

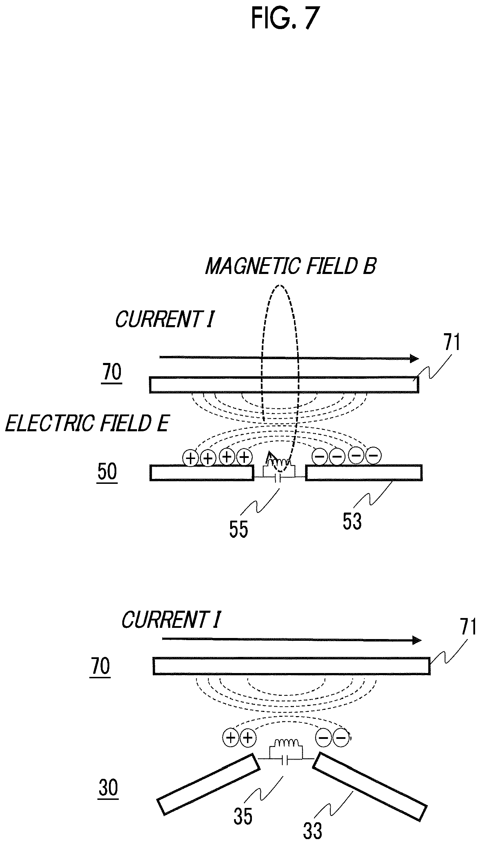

Next, an effect of the coil unit according to the present embodiment, that is, the effect of reducing the interference with the near transmission coil 203 (Fig. 2) will be described with reference to Figs. 6 and 7.

Fig. 6 is a diagram schematically showing a coil unit of the related art (upper view) in which a balun is provided in a wiring line and a coil unit according to the present embodiment (lower view). Both show a simplified unit in which the number of coil elements is 5 × 3, and the electrical wire and the cable connected part 37 other than the signal line shown in Fig. 3 are omitted.

A coil unit 50 of the related art has a structure in which a signal line that is led from the signal detection circuit of each coil element is bundled at substantially a center of an arrangement of coil elements, and a wiring line passes through the center of the arrangement. On the other hand, the coil unit 30 according to the present embodiment has a structure in which the signal line that is led from the signal detection circuit of each coil element is bundled to any of two assembly wiring lines and two assembly wiring lines run in a zigzag shape. The baluns are disposed at the folding-back points of each wire.

Fig. 7 shows a relationship between the coil unit 50 and a ring conductor 71 through which a largest current flows in a near RF transmission coil 70 (birdcage-type coils), and a relationship between the coil unit 30 and the ring conductor 71. As shown on the upper side of Fig. 7, in a case where the reception coil is mounted such that the ring conductor 71 of the RF transmission coil and the wiring line 53 of the coil unit 50 are parallel to each other, a magnetic field B is generated around the ring conductor 71 as a current I flows in the ring conductor 71, and an electric field E is strongly generated in the vicinity of the ring conductor 71 by an electromagnetic action. In the thin reception coil, the wiring line is closer to the ring conductor 71 than in the related art, and thus, the electric field is formed, both are strongly coupled to each other, influenced by the strong electric field E. This coupling is larger as a distance between the ring conductor and the wire decreases and the length overlapping in relation to each other increases. As a result, a strong voltage is applied to both ends of a balun 55, and a resonance current in the balun 55 increases, which causes abnormal heat generation.

On the other hand, since the coil unit 30 of the present embodiment has a shape in which the wiring line is bent on both sides of the balun 35, even in a case where the reception coil is set such that the ring conductor 71 of the transmission coil 70 is parallel to the arrangement direction (right-left direction in Fig. 6) of the coil element, the assembly wiring line 33 is not parallel to the ring conductor 71 on both sides and is less likely to overlap the ring conductor 71 as shown on the lower side of Fig. 7. Therefore, the influence of the electric field E generated around the ring conductor 71 is significantly reduced as compared with the case of the coil unit in the related art, and the coupling of both is weakened.

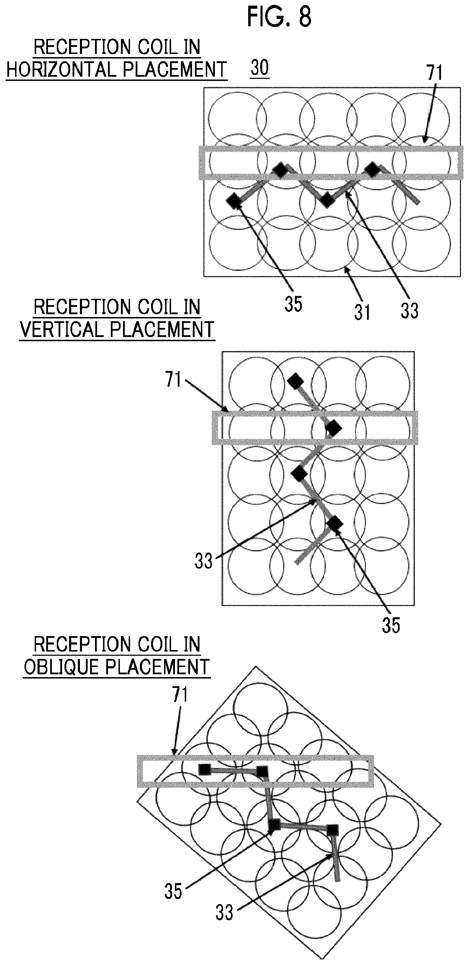

In addition, even in a case where the angle of the reception coil is changed and the reception coil is set from the horizontal placement in the upper view to the vertical placement as in the center view of Fig. 8, the reception coil is not parallel to the conductor 71 of the transmission coil likewise, so that the influence of the coupling with the transmission coil is reduced. In addition, as shown in the lower view of Fig. 8, even in a case where a part of the wiring line overlaps with the conductor 71 of the transmission coil in parallel by setting the reception coil obliquely, the other parts of the wiring line do not overlap with the conductor 71, so that the influence of the electromagnetic coupling can be reduced likewise.

In the above description, a case where the wiring line of the reception coil and the ring conductor of the transmission coil are near has been described as an example, but the same effect can be obtained even in a case where the rung conductor of the transmission coil is near.

As described above, in the coil unit of the present embodiment, the wiring line that bundles each signal line of the coil element is configured to run in a zigzag shape with respect to the arrangement direction of the coil element, and the baluns are disposed at the folding-back points, so that it is possible to effectively suppress the high-frequency circuit comprised in the reception coil from being coupled with the conductor of the near transmission coil and to suppress heat generation in the vicinity of the baluns. In addition, effectiveness of the effect of preventing interference between the coil element and the wiring line by the balun can be improved. As a result, it is possible to contribute to improvement of image quality in MRI equipped with the coil unit according to the present embodiment.

### Modification Example 1

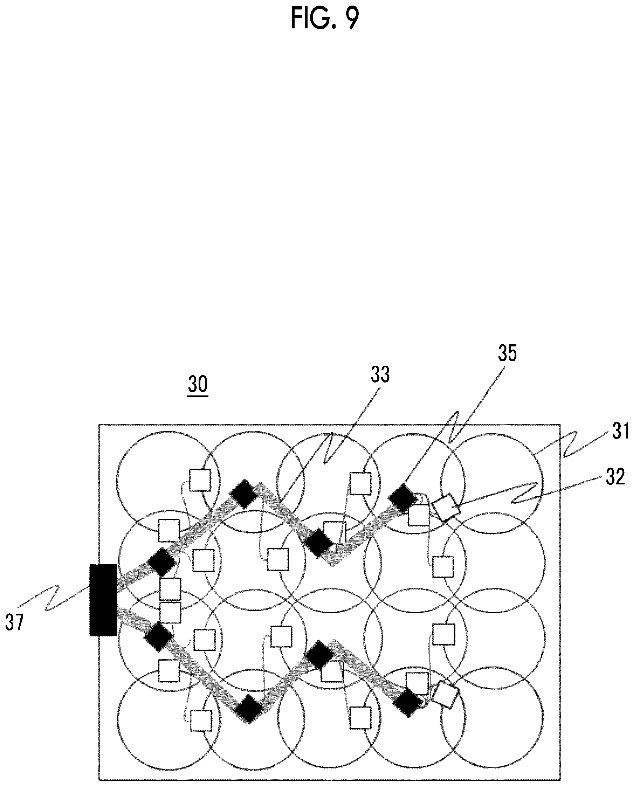

In Fig. 3, an example of comprising three assembly wiring lines 33 is shown, but the number of assembly wiring lines 33 can be changed depending on the position of the signal detection circuit 32 to which the signal lines bundled as the assembly wiring lines 33 are connected or the length of the signal lines, and, for example, two assembly wiring lines 33 may be provided even in a case where the same coil element is arranged in a (5 × 3) array as shown in Fig. 9. In addition, it is needless to say that the number of assembly wiring lines 33 can vary depending on a difference in arrangement or the number of coil elements.

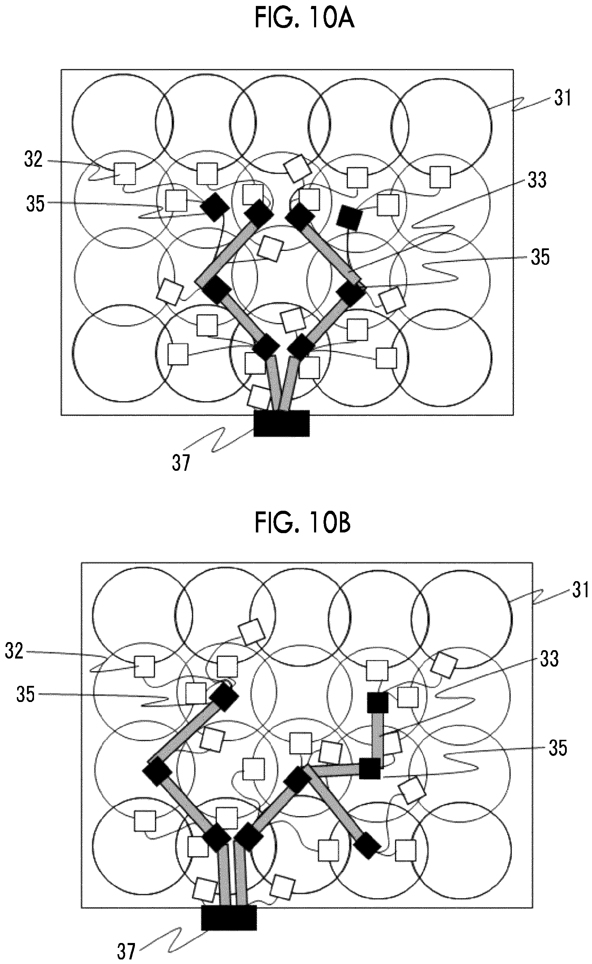

In addition, in Fig. 3, an example in which the cable connected part 37 is provided at the end part of the coil unit 30 in a longitudinal direction is shown, but as shown in Fig. 10A, the cable connected part 37 may be provided at the end part of the coil unit 30 in a lateral direction, the zigzag-shaped wiring line and the balun can be provided, and the number of the wiring lines and the position of the balun can be changed even in that case. For example, as shown in Fig. 10A, baluns may be disposed for one or a plurality of signal lines in front of the assembly wiring line 33 that runs in a zigzag manner in a case where the signal lines are sequentially bundled.

In addition, in Fig. 3 and Fig. 10A, an example in which the cable connected part 37 is provided in a central portion of the end part of the coil unit 30 in the longitudinal direction or the lateral direction is shown, but the cable connected part 37 may be provided in a portion other than the central portion of the end part as shown in Fig. 10B, and the number of wiring lines and the position of the balun can be changed even in that case. For example, as shown in Fig. 10B, the balun may be disposed for one or a plurality of signal lines in front of the assembly wiring line 33 that runs in a zigzag manner in a case where the signal lines are sequentially bundled.

The same effect as that of Embodiment 1, which includes the effect of reducing the electromagnetic coupling between the RF transmission coil and the conductor, can be obtained even in these modification examples.

### Modification Example 2: Modification Example of Balun

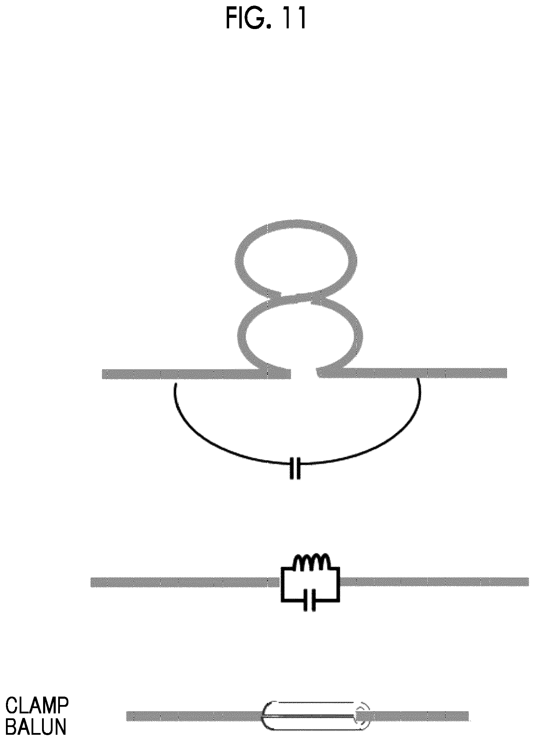

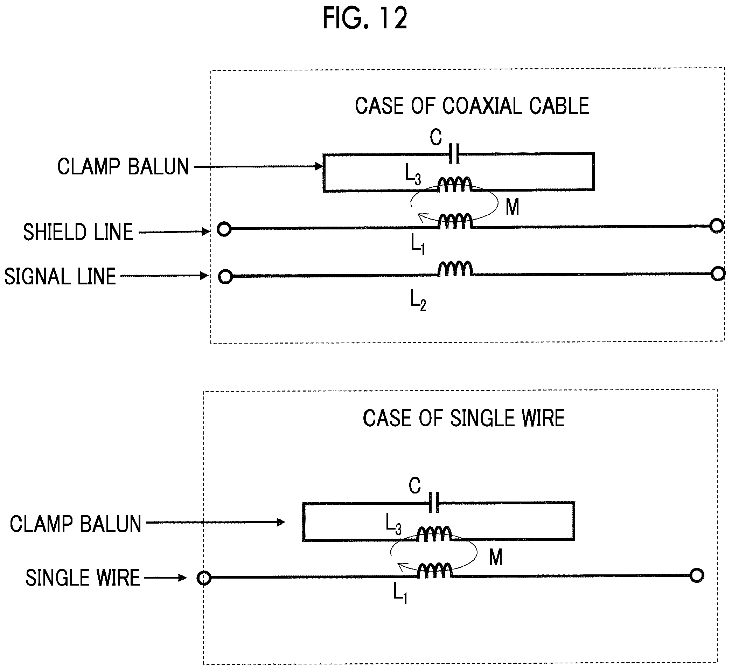

In Embodiment 1, although a case where the LC parallel resonance circuit is formed in the wiring line itself has been described as the balun provided in the wiring line, the balun may be a unit other than the parallel resonance circuit shown in Fig. 4 as long as the interference of the high-frequency circuit of the coil unit can be prevented. Figs. 11, 12A, and 12B show some modification examples of the balun.

One example is an example in which the shape of the wiring line itself is set to a figure-eight shape instead of a solenoid shape as shown in the upper view of Fig. 11. The insertion of the capacitor into the shield is the same as that in Fig. 4. The center view of Fig. 11 is an example in which an LC parallel resonance circuit consisting of an inductor L and a capacitor C of the electronic element is inserted into the shield line. This modification example is a simple unit in a case where the balun is provided in a single wire, particularly the wiring line for supplying power to a component of the coil element.

The lower view of Fig. 11 shows an example in which a clamp-type balun (hereinafter, referred to as a clamp balun) is used. The clamp balun is a component that functions as a balun by combining two components that can be divided, and constitutes an LC parallel resonance circuit as shown in equivalent circuits of Figs. 12A and 12B, and in a case of a coaxial cable, increases impedance of a shield line by generating mutual inductance M between an inductor component L3 of the clamp balun and an inductor component L1 the shield line of the coaxial cable, so that the clamp balun functions as a balun that blocks a high-frequency current flowing in the shield line. Further, even in a case of the single-wired wiring line, the clamp balun functions as a balun that blocks a high-frequency current by generating the mutual inductance M with the inductor component L1 of the single wire.

Since the clamp balun can be attached to the wiring line or the coaxial cable by interposing the wiring line or the coaxial cable from both sides, there is an advantage in that the balun can be provided even afterward and at any position.

### Embodiment 2

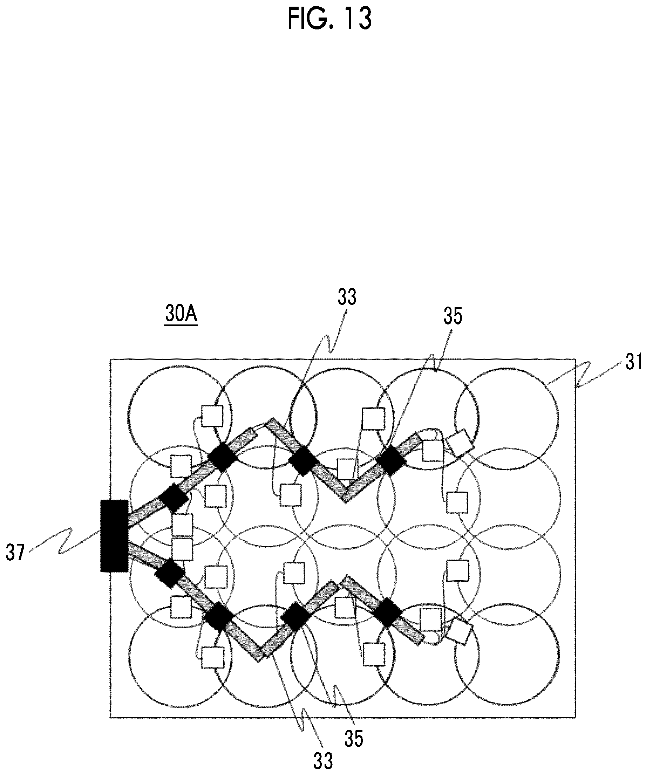

In a coil unit of the present embodiment, the balun 35 is provided between a folding-back point and another folding-back point of the assembly wiring line 33 disposed in a zigzag shape. Fig. 13 shows an example of the coil unit according to the present embodiment. In this figure, for the sake of simplicity of description, a relatively small coil unit in which coil elements are arranged in three rows and five columns is shown.

In a coil unit 30A of the present embodiment, as in the coil unit 30 in Fig. 3, a plurality of (three in the figure) assembly wiring lines 33 that bundle the signal lines led from the signal detection circuits 32 of the coil elements 31 are disposed to run while being folded back a plurality of times from one end of the coil unit 30A to the other end where the cable connected part 37 is provided. A plurality of baluns 35 are provided in each assembly wiring line 33, and the balun 35 is provided in the assembly wiring line 33 between a folding-back point and another folding-back point. The position of the balun 35 is not limited as long as the position is between a folding-back point and another folding-back point, but it is preferable to be a position biased to any of the folding points.

In Fig. 13, the coil unit in which all the baluns 35 are provided at positions of the assembly wiring line 33 other than the folding-back point is shown, but the balun can also be provided at the folding-back points, and in this case, the balun (the balun provided on one side of the wiring line) close to the folding-back point at which the balun is provided may be omitted. It should be noted that it is preferable that at least one balun is provided in a wiring line between a folding-back point and a next folding point (including one folding-back point), and the distance between one balun and another balun on one side of the wiring line is 1/16 or less of the wavelength λ of the magnetic resonance signal.

The configuration of the balun 35 is the same as that of the Embodiment 1, and a structure in which the assembly wiring line 33 is formed in a solenoid shape and the capacitor is connected to the shield line (Fig. 8) or a clamp balun that constitutes the parallel resonance circuit (Fig. 11) can be adopted. In addition, regarding the position where the balun 35 is provided, similarly to Embodiment 1, in a case of a solenoid-shaped balun, it is preferable that the surface of the coil element and the axis of the solenoid are disposed in parallel, and it is preferable that the balun is disposed symmetrically with respect to the center of the coil element.

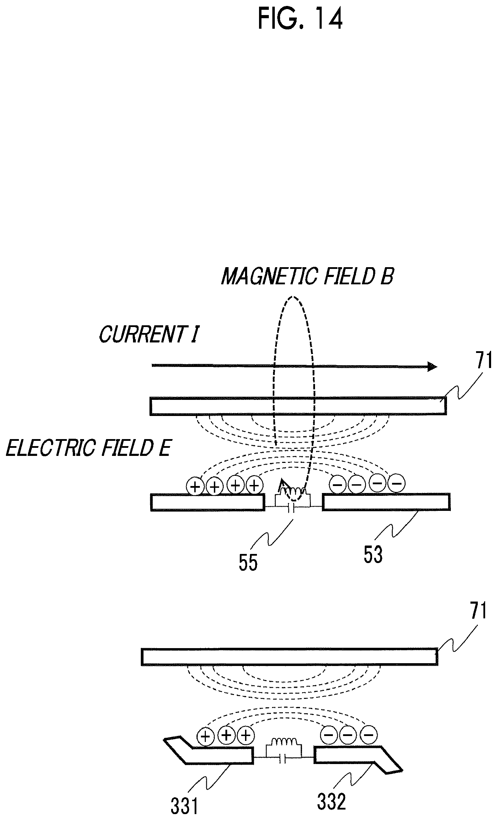

In the coil unit 30A according to the present embodiment, by appropriately disposing the balun 35, it is possible to prevent interference of the high-frequency circuit (element, electronic component, signal line, and the like) included in the coil unit 30A, and it is possible to suppress interference with the conductor even in a case where the conductor (ring or rung) of the RF transmission coil 203 is close. An effect of preventing interference with the RF transmission coil in the coil unit of the present embodiment will be described with reference to Fig. 14.

The upper view of Fig. 14 is the same view as the upper view of Fig. 7, and shows a state in which the reception coil is disposed such that the wiring line 53 is parallel to the conductor 71 of the RF transmission coil, and interference occurs because of a current flowing in the conductors 71. On the other hand, in the coil unit 30A of the present embodiment, as shown in the lower view of Fig. 14, even in a case where straight portions 331 and 332, which are parts of the zigzag-shaped wiring line, are parallel to the conductors of the RF transmission coils, lengths of the wiring line on both sides of the balun 35 are equal to or less than half of the length between a folding-back point and another folding-back point (the length of one side), so that the magnitude of an electric field generated across the balun 35 is smaller than the magnitude of an electric field generated in a straight wire line without folding-back. That is, the interference between the RF transmission coil and the conductor is significantly reduced. In particular, as shown in the figure, since the balun 35 is at a position deviated from the center of one side, the length of the portion 331 is shorter than the length of the portion 332, it is possible to further reduce the interference with the RF transmission coil.

As described above, also in the present embodiment, as in Embodiment 1, the effect of reducing the interference with the RF transmission coil can be obtained, and the influence of the interference, for example, image quality degradation due to a decrease in irradiation uniformity, abnormal heat generation in balun and the vicinity thereof, and the like can be suppressed.

Although Embodiment 2 has been described with reference to Figs. 13 and 14, also in the present embodiment, the modification examples described in Embodiment 1, for example, the modification example of the disposition of the assembly wiring line 33 and the cable connected part 37 and the modification example of the balun can be adopted, and the same effect can be obtained. In addition, for the position where the balun is provided, Embodiment 1 and Embodiment 2 can be appropriately combined, so that restriction on the structure for the position where the balun is provided can be reduced, and a suitable position can be easily realized.

### Explanation of References

20: MRI apparatus
21: gantry
201: static magnetic field magnet
202: gradient magnetic field coil
203: RF transmission coil
204: RF reception coil
205: subject
206: table
30: RF coil unit
31: coil element
32: signal detection circuit
33: assembly wiring line
35: balun
37: cable connected part
38: support body

## Claims

1. A coil unit of an MRI apparatus, comprising:
a plurality of coil elements arranged in a two-dimensional direction,
a wiring line connected to each coil element and configured to transmit a signal or electricity; and
baluns provided at a plurality of positions of the wiring line,
wherein at least a part of the wiring line runs from one end toward the other end in an arrangement direction of the coil elements while being folded back in a direction oblique to the arrangement direction.

2. The coil unit according to claim 1,
wherein at least a part of the baluns is disposed at a folding-back point of the wiring line.

3. The coil unit according to claim 1,
wherein at least a part of the baluns is disposed between a folding-back point and a next folding-back point of the wiring line.

4. The coil unit according to claim 1,
wherein at least one balun is disposed on a wiring line between one folding-back point and a next folding-back point.

5. The coil unit according to any of claims 1 to 4, further comprising:
a connecting part configured to connect the wiring line to a cable of an MRI apparatus,
wherein the connecting part is provided at an end part of an arrangement of the coil elements in a longitudinal direction.

6. The coil unit according to any of claims 1 to 4, further comprising:
a connecting part configured to connect the wiring line to a cable of an MRI apparatus,
wherein the connecting part is provided at an end part of an arrangement of the coil elements in a lateral direction.

7. The coil unit according to any preceding claim,
wherein a length of the wiring line to one folding-back point and a length of the wiring line to the other folding-back point are different from each other with the balun interposed therebetween.

8. The coil unit according to any preceding claim,
wherein a distance between adjacent folding-back points of the wiring line is 1/16 or less of a wavelength of a high-frequency signal transmitted and received by an MRI apparatus.

9. The coil unit according to any preceding claim,
wherein the balun is a parallel resonance circuit, and a resonance frequency is f0 ± 10% in a case where a reference frequency of an MRI apparatus is denoted by f0.

10. The coil unit according to any of claims 1 to 9,
wherein the balun includes a balun composed of a solenoid coil or a figure-eight-shaped coil formed of a shield line of the wiring line and a capacitor connected in parallel to both ends of the solenoid coil or the figure-eight-shaped coil.

11. The coil unit according to claim 10,
wherein the balun includes a balun composed of a solenoid coil or a figure-eight-shaped coil formed of the wiring line connected to the coil elements and a capacitor connected in parallel to both ends of the solenoid coil or the figure-eight-shaped coil.

12. The coil unit according to any of claims 1 to 9,
wherein the balun is an LC circuit connected in series to the wiring line.

13. The coil unit according to any of claims 1 to 9,
wherein the balun is a clamp-type balun mounted on an outer periphery of the wiring line.

14. The coil unit according to claim 13,
wherein the clamp-type balun is mounted at a mounting position in the wiring line to include a plurality of the wiring lines connected to the coil elements.

15. A magnetic resonance imaging apparatus comprising:
an RF transmission coil configured to generate a high-frequency magnetic field in an imaging space in which a static magnetic field is formed; and
an RF reception coil configured to receive a nuclear magnetic resonance signal generated from a subject placed on the imaging space,
wherein the RF reception coil is the coil unit according to any of claims 1 to 14.
